# FASCICULE DE BREVET EUROPEEN

(11) **EP 3 593 360 B1**
(45) Date de publication et mention de la délivrance du brevet: **03.01.2024**
(21) Numéro de dépôt: 18708146.8
(22) Date de dépôt: 08.03.2018
(51) Int. Cl.: H03K 19/17764, H03K 19/17768, G21D 3/00

(54) **CIRCUIT LOGIQUE PROGRAMMABLE DE COMMANDE D'UNE INSTALLATION ÉLECTRIQUE, EN PARTICULIER UNE INSTALLATION NUCLÉAIRE ET DISPOSITIF ASSOCIÉ**
PROGRAMMIERBARE LOGIKSCHALTUNG ZUR STEUERUNG EINER ELEKTRISCHEN ANLAGE, INSBESONDERE EINER KERNANLAGE, UND ZUGEHÖRIGE STEUERUNGSVORRICHTUNG
PROGRAMMABLE LOGIC CIRCUIT FOR CONTROLLING AN ELECTRICAL FACILITY, IN PARTICULAR A NUCLEAR FACILITY AND ASSOCIATED CONTROL DEVICE

(30) Priorité: 08.03.2017 FR 1751903
(43) Date de publication de la demande: 15.01.2020
(73) Titulaire: FRAMATOME, 92400 Courbevoie (FR)
(72) Inventeur: ALLORY, Mathieu, 94360 Bry-sur-Marne (FR); DUPUY, Nicolas, 92130 Issy-les-Moulineaux (FR)
(74) Mandataire: Lavoix
(86) Numéro de dépôt international: PCT/EP2018/055817
(87) Numéro de publication internationale: WO 2018/162668

(56) Documents cités:
- EP-A1- 3 107 212
- US-A1- 2002 052 673
- US-A1- 2015 204 944
- BATTLE R E ET AL: "Reactor protection system design using application-specific integrated circuits", INSTRUMENTATION IN THE POWER INDUSTRY, PROCEED,, vol. 35, 1 juin 1992 (1992-06-01), pages 389-396, XP009106740, ISSN: 0074-056X

## Description

La présente invention concerne un circuit logique programmable de commande d'une installation électrique, en particulier une installation nucléaire, le circuit logique programmable comprenant une unité fonctionnelle comprenant :
- une pluralité de types de blocs fonctionnels, deux types de blocs fonctionnels distincts étant propres à exécuter au moins une fonction distincte,
- au moins un module de traitement propre à recevoir au moins une séquence de bloc(s) fonctionnel(s) à exécuter, et
- au moins une mémoire interne configurée pour stocker au moins ladite séquence.

Par ailleurs, la présente invention concerne également un dispositif de commande d'une installation électrique, en particulier une installation nucléaire, le dispositif de commande comprenant au moins un tel circuit logique programmable.

US 2015/0204944 A1 décrit un circuit logique programmable de commande d'une installation nucléaire.

On connaît du document EP 2 988 420 A1 un système de commande d'installation électrique basé sur une carte électronique comprenant deux circuits logiques programmables FPGA (de l'anglais *Field Programmable Gate Array*)*.*

Un premier FPGA joue le rôle de maître et comprend un ensemble de blocs fonctionnels comprenant autant de blocs fonctionnels de même type, par exemple de type « ET », que le nombre d'instances de ce type de bloc pour une application donnée de contrôle commande d'une installation nucléaire. Le deuxième FPGA est connecté point à point aux entrées et sortie du premier FPGA et joue le rôle de matrice de connexion physique des blocs fonctionnels du premier FPGA.

A chaque modification de l'application de contrôle commande considérée ou en cas de changement d'application de contrôle commande, une reprogrammation en langage de description de matériel VHDL (de l'anglais *very high speed integrated circuit (VHSIC) hardware description language (HDL)*) ou Verilog et une requalification du deuxième FPGA connectant les blocs fonctionnels les uns aux autres est nécessaire.

En effet dans un contexte de contrôle commande d'installation nucléaire, chaque conception de FPGA doit être qualifiée très soigneusement en employant des processus complexes de développement et de vérification.

Une telle étape de reprogrammation en langage de description de matériel, VHDL ou Verilog par exemple, requiert de l'opérateur des connaissances de ce langage, et la requalification requiert temps et efforts de vérification.

Afin de pallier ces inconvénients une solution est décrite dans le document EP 3 107 212 A1 et basée, sur la mise en oeuvre d'un FPGA comprenant également un ensemble de blocs fonctionnels exécutés en parallèle selon plusieurs cycles successifs pour obtenir le résultat d'une application donnée de contrôle commande d'une installation nucléaire. Selon cette solution le circuit FPGA comprend au moins autant de blocs fonctionnels de même type que le nombre d'instances de ce type de bloc. De plus, dans ce document, un convoyeur de données permet de faire transiter des valeurs binaires et analogiques entre les blocs fonctionnels présentant chacune une architecture spécifique leur permettant respectivement d'extraire du convoyeur et de transmettre au convoyeur leurs données d'entrée et de sortie.

Toutefois, cette solution requiert un nombre de blocs fonctionnels de même type important et défini de manière empirique à partir de l'expérience acquise en conception de système de contrôle commande d'installation nucléaire. De plus, l'exécution en parallèle des blocs fonctionnels au cours de plusieurs cycles successifs nécessaires pour obtenir le résultat associé à une application, requiert la mise en oeuvre d'une synchronisation, notamment au moyen de temporisation(s), de sorte à garantir le déterminisme des données transitant entre chaque bloc fonctionnel et entre chaque cycle.

Le but de l'invention est donc de proposer une solution alternative, pour le contrôle commande d'installation nucléaire, basée sur la mise en oeuvre de circuit logique programmable pour laquelle, en cas de changement d'application de contrôle commande, une reprogrammation en langage VHDL ou une requalification du module de traitement est évitée, tout en réduisant le nombre de ressources logiques mises en oeuvre et tout en répondant plus simplement aux exigences de démonstration déterministe de sûreté requises pour un dispositif de sûreté, tel qu'un dispositif de commande d'une installation nucléaire.

A cet effet, l'invention a pour objet un circuit logique programmable selon la revendication 1.

Le circuit logique programmable selon l'invention permet alors de réduire significativement le nombre de ressources logiques et donc la taille et la consommation énergétique du circuit logique programmable, tout en garantissant le déterminisme de l'application de contrôle commande grâce à l'exécution en série des blocs fonctionnels appelés selon leur séquence (i.e. ordre) d'exécution au cours d'un unique cycle (un cycle correspondant à un temps durant lequel les données d'entrée du circuit logique programmable sont fixées en mémoire et ne seront réévaluées qu'au cycle suivant). En d'autres termes, selon la présente invention, un seul cycle, correspondant à l'exécution de la série de blocs fonctionnels listée dans la séquence, est nécessaire pour obtenir le résultat d'une application de contrôle commande donnée.

Suivant d'autres aspects avantageux de l'invention, le circuit logique programmable est selon l'une quelconque des revendications 2 à 9.

L'invention a également pour objet un dispositif de commande selon la revendication 10.

Suivant d'autres aspects avantageux de l'invention, le dispositif de commande est selon l'une quelconque des revendications 11 à 18.

Ces caractéristiques et avantages de l'invention apparaitront à la lecture de la description qui va suivre, donnée uniquement à titre d'exemple non limitatif, et faite en référence aux dessins annexés, sur lesquels :
- la figure 1 est une représentation schématique d'un circuit logique programmable selon l'invention;
- la figure 2 est une représentation illustrant un exemple d'application de contrôle commande à exécuter;
- la figure 3 est une représentation schématique de la connexion du circuit logique programmable selon l'invention à un module de maintenance et de diagnostic ;
- la figure 4 est une représentation schématique d'un dispositif de commande selon l'invention comprenant, selon un mode de réalisation, le circuit logique programmable de la figure 1 ;
- les figures 5 et 6 représentent respectivement deux variantes de dispositifs de commande comprenant une pluralité de circuits logiques programmables représentés en figure 1.

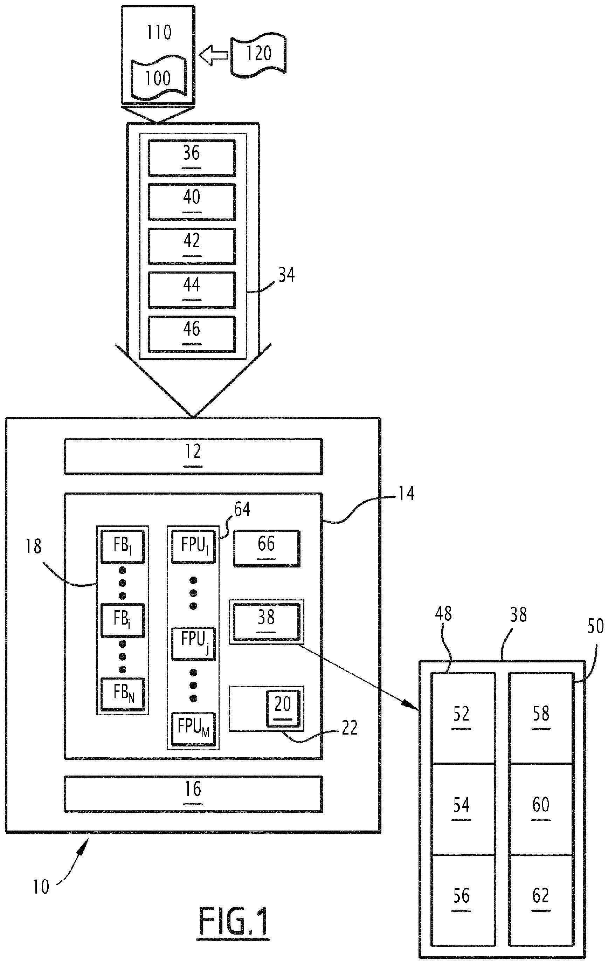

Sur la figure 1, le circuit logique programmable 10 est un module de traitement (PM de l'anglais *Processing Module*)*.* Plus précisément, le circuit logique programmable 10 est réalisé sous forme d'une structure électronique, telle qu'un réseau de portes programmables ou FPGA (de l'anglais *Field-Programmable Gate Array*)*.*

Un tel FPGA 10 comprend un module 12 de contrôle des signaux d'entrées, une unité fonctionnelle 14 (OPU de l'anglais *Operating Unit*)*,* et un module 16 de contrôle des signaux de sortie.

L'unité fonctionnelle 14 comprend une pluralité 18 de N types de blocs fonctionnels FB₁, ... FBᵢ, ..., FB_{N} distincts avec *N* un entier et i l'indice de type de bloc fonctionnel compris entre un et N.

Deux types de blocs fonctionnels distincts sont propres à exécuter au moins une fonction distincte. Par « fonction », on entend une fonction propre à être mise en oeuvre par un FPGA.

Selon la présente invention, l'unité fonctionnelle comprend un seul bloc fonctionnel de chaque type.

Chaque bloc fonctionnel est par ailleurs qualifié une bonne fois pour toute lors de la conception du circuit logique programmable et, selon la présente invention, est par la suite uniquement appelé pour être exécuté au cours d'une application de contrôle commande sans qu'aucune requalification ne soit nécessaire en cas de changement/modification d'application de contrôle commande.

Chaque instance de bloc peut en outre disposer, si nécessaire, d'un espace de mémoire interne 20 dédié d'un module 22 d'exécution de l'unité fonctionnelle 14, permettant de stocker des valeurs persistantes d'un cycle d'exécution à l'autre.

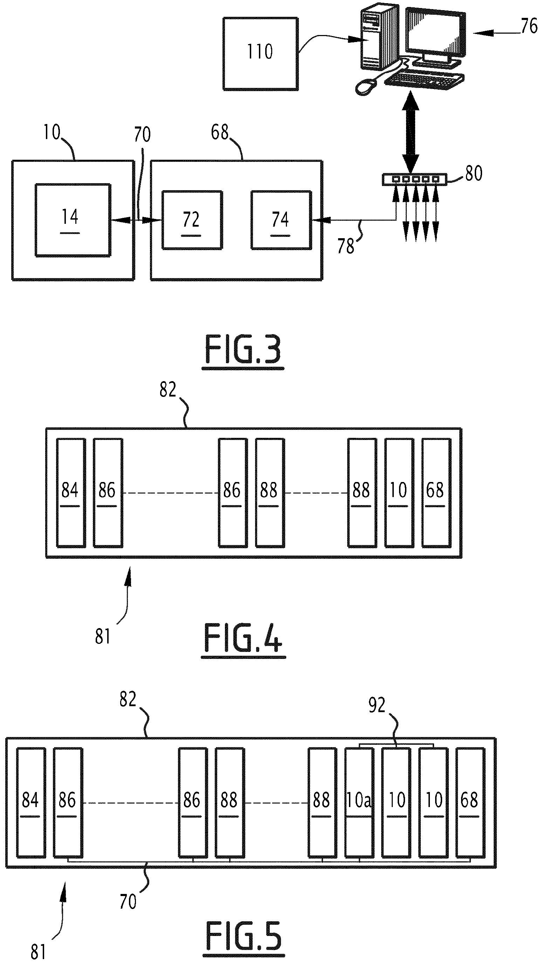

L'ensemble des fonctions propres à être mises en oeuvre par un FPGA selon la présente invention sont donc implémentées (i.e. programmés selon une étape préliminaire) une bonne fois pour toute en VHDL. Leurs caractéristiques sont par exemple listées et mémorisées au sein d'un fichier bibliothèque 100 stocké au sein d'une mémoire, non représentée, d'un générateur automatique 110 de données de configuration d'une centrale de maintenance 76 (illustrée sur la figure 3) distante et distincte du circuit logique programmable 10 selon la présente invention.

En d'autres termes, le fichier bibliothèque 100 décrit les caractéristiques des fonctions pouvant être mises en oeuvre par chaque bloc fonctionnel tel que programmé.

Un tel fichier bibliothèque 100 comprend par exemple pour chaque bloc fonctionnel :
- son type,
- la description d'au moins une fonction qu'il est propre à mettre en oeuvre,
- son identifiant correspondant à un code arbitraire prédéterminé
- son nombre et/ou sorte d'entrées,
- son nombre et/ou sorte de sorties,
- son nombre et/ou sorte de paramètres qu'il est propre à utiliser.

Un tel fichier bibliothèque 100 est élaboré préalablement et utilisé par un générateur automatique 110 de données de configuration de la centrale de maintenance 76, permettant de traduire automatiquement un ensemble de diagrammes fonctionnels 120 en programme applicatif 34.

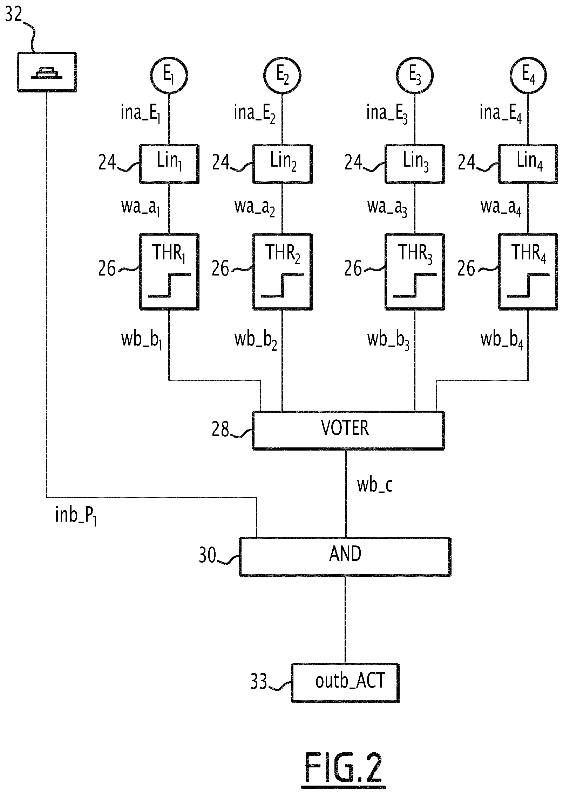

La figure 2 illustre un diagramme fonctionnel 120 d'un exemple d'application de contrôle commande à exécuter. Une telle application correspond à la détection de température limite en quatre points distincts d'un réacteur nucléaire.

Une telle application est générée par un opérateur à partir d'un éditeur graphique relié au générateur automatique 110 de programme applicatif 34 sans requérir de connaissances particulières en langage de description de matériel VHDL ou Verilog.

Le générateur automatique 110 de programme applicatif 34 est propre à convertir les données d'un tel diagramme fonctionnel 120 par le générateur 110 de programme applicatif 34 en au moins une séquence 46 de blocs fonctionnels à exécuter, chaque bloc fonctionnel de la séquence mettant en oeuvre les fonctions conformes à celles préalablement programmées et répertoriées dans le fichier bibliothèque 100.

Quatre types 24, 26, 28, 30 de blocs fonctionnels distincts sont nécessaires pour la mise en oeuvre d'une telle application de contrôle commande, à savoir les quatre types LIN, THR, VOTER et AND qui sont graphiquement reliés par des liaisons orientées représentant les relations de causalité entre blocs fonctionnels.

Plus précisément, l'opérateur définit graphiquement le nombre de signaux d'entrée de l'application de contrôle commande à savoir E1, E2, E3, et E4 qui correspondent, par exemple à différents points de mesure d'un réacteur nucléaire.

Selon cette application de contrôle commande, les signaux électriques des points Ei (i=1 à 4) sont ensuite chacun propres à être convertis au moyen d'un bloc fonctionnel de type LIN en une donnée physique, ici une température.

Puis, la température obtenue en sortie du bloc fonctionnel 24 de type LIN est comparée à un seuil de température au moyen d'un bloc fonctionnel 26 de type THR ayant pour paramètre ce seuil de température à savoir par exemple 100°C.

L'application de contrôle commande visée comprend ensuite une fonction de vote mise en oeuvre par bloc fonctionnel 28 VOTER appliquée aux quatre signaux associés à chaque point d'entrée. La fonction de vote est par exemple une fonction de vote 2/4 apte à confirmer ou infirmer (i.e. résultat binaire) la comparaison au seuil de température, à partir du moment où au moins deux comparaisons sur quatre ont le même résultat.

Enfin, l'application de contrôle commande visée est propre à prendre en compte, au moyen d'un bloc fonctionnel 30 AND, l'activation d'un bouton poussoir 32 (propre à être actionné manuellement par un opérateur) inhibiteur de résultat. En d'autres termes, le bloc fonctionnel 30 AND reçoit deux entrées binaires correspondant respectivement aux signaux de sortie du bouton poussoir 32 et du bloc fonctionnel 28 VOTER et délivre en sortie le résultat 33 binaire du bloc fonctionnel VOTER si le bouton poussoir 32 n'a pas été actionné, et le résultat 33 binaire contraire sinon.

Ainsi, pour cet exemple d'application de contrôle commande, le fichier bibliothèque 100 utilisé par le générateur automatique 110 est par exemple sous la forme du tableau suivant :

| Type | Code arbitrai re du FB | Description fonction | Entrées | Sorties | Paramètres |
|---|---|---|---|---|---|
| LIN | 0x01 | Conversion linéaire d'un signal électrique en une donnée physique | 1 analogique | 1 analogique | aucun |
| THR | 0x02 | Comparaison à une valeur seuil | 1 analogique | 1 binaire | 1 analogique: valeur de seuil |
| VOTER | 0x03 | Fonction de vote 2/4 | 4 binaires | 1 binaire | aucun |
| AND | 0x04 | Fonction logique « ET » entre deux entrées | 2 binaires | 1 binaire | aucun |

En relation avec la figure 1, le bloc fonctionnel FB, est par exemple de type LIN et le code 0x01 lui est alloué sur la carte FPGA, le bloc fonctionnel FBᵢ₌₅ est de type THR et le code 0x02 lui est alloué, le bloc fonctionnel FBᵢ₌₁₂ est de type VOTER et le code 0x03 lui est alloué, et le bloc fonctionnel FBᵢ₌₁₈ est de type AND et le code 0x04 lui est alloué.

A partir du diagramme représenté sur la figure 2, et du fichier bibliothèque 100 décrit ci-dessus, un ensemble de fichiers informatiques de configuration formant un programme applicatif 34 est automatiquement généré.

Un tel programme applicatif 34 comprend notamment :
- un fichier de configuration 36 de la mémoire 38 de l'unité fonctionnelle 14 correspondant à une table associant à au moins un signal d'entrée/sortie du circuit logique programmable 10 une adresse dans sa mémoire,
- un fichier 40 de valeur(s) de paramètre(s) de bloc(s) fonctionnel(s) propre(s) à exécuter au moins une fonction utilisant un paramètre,
- un fichier 42 listant, pour chaque bloc fonctionnel, la ou les adresse(s) de la mémoire allouée(s) à une ou des entrée(s) de ce bloc fonctionnel,
- un fichier 44 listant, pour chaque bloc fonctionnel, la ou les adresse(s) de la mémoire allouée(s) à une ou des sortie(s) de ce bloc fonctionnel,
- une séquence 46 de bloc(s) fonctionnel(s) à exécuter

La mémoire 38 de l'unité fonctionnelle 14 comprend au moins deux espaces 48 et 50 de stockage de données dédiés respectivement à des données binaires (booléens codés sur deux bits distincts) et à des données analogiques (nombres flottants codés par exemple sur trente-deux bits). Dans une variante non représentée, la mémoire 38 de l'unité fonctionnelle 14 comprend en outre un espace de stockage de données dédié aux valeurs de paramètres du fichier 40.

L'espace 48 de stockage de données binaires est lui-même hiérarchisé en au moins trois sous-espaces, à savoir : un premier sous-espace 52 dédié aux données binaires d'entrées du circuit logique programmable 10, un deuxième sous-espace 54 dédié aux données binaires temporaires obtenues en cours d'exécution de la séquence 46, un troisième sous-espace 56 dédié aux données binaires de sorties du circuit logique programmable.

De même, l'espace 50 de stockage de données analogiques est lui-même hiérarchisé en au moins trois sous-espaces, à savoir : un premier sous-espace 58 dédié aux données d'entrées analogiques du circuit logique programmable 10, un deuxième sous-espace 60 dédié aux données analogiques temporaires obtenues en cours d'exécution de la séquence 46, un troisième sous-espace 62 dédié aux données analogiques de sorties du circuit logique programmable.

Le fichier de configuration 36 de la mémoire 38 est configuré pour être lu par le module d'exécution 22 de l'unité fonctionnelle 14 au cours d'un unique cycle d'exécution l'application de contrôle commande (correspondant par exemple à celle représentée sur la figure 2).

Lors de l'exécution de la séquence 46, le module d'exécution 22 lit dans le fichier de configuration 36 où sont stockées dans la mémoire 38 les valeurs des entrées et sorties de l'application dans son ensemble.

En d'autres termes, le fichier de configuration 36 est un tableau d'allocation, dans les différents sous-espaces (i.e. registres) mémoire, d'adresses mémoire aux entrées et sorties du circuit logique programmable 10.

Les cinq valeurs d'entrées sont, selon l'exemple d'application de contrôle commande représenté sur la figure 2, à quatre valeurs analogiques ina_E1, _ina_E2, ina_E3 et ina_E4 correspondant aux signaux électriques représentatifs de mesures de température respectivement aux points E1 à E4 et une valeur binaire inb_P1 représentative de l'activation/désactivation du bouton poussoir 32.

La valeur de sortie outb_ACT est délivrée après exécution des blocs fonctionnels selon la séquence 46 de blocs fonctionnels.

Ainsi, pour cet exemple d'application de contrôle commande illustré sur la figure 2, le fichier de configuration 36 est, par exemple, sous la forme du tableau suivant :

| Type espace de stockage | Analogique 50 | | | | Binaire 48 | |
|---|---|---|---|---|---|---|
| Sous-espace | Entrée 58 | | | | Entrée 52 | Sortie 56 |
| Adresse(s) mémoire | 0x0001 à 0x0004 | 0x0005 à 0x0008 | 0x0009 à 0x0012 | 0x0013 à 0x0014 | 0x0000 | 0xF800 |
| Nom de la valeur | ina_E1 | ina_E2 | ina_E3 | ina_E4 | inb_P1 | outb_ACT |

Selon la présente invention, la séquence 46 de bloc(s) fonctionnel(s) à exécuter est un fichier informatique listant, à partir des liens de causalité du diagramme, l'ordre d'instanciation des blocs fonctionnels à exécuter en série par le module d'exécution 22 de l'unité fonctionnelle 14 pour réaliser l'application de contrôle commande désirée.

La séquence 46 est un fichier informatique, par exemple, représenté sous la forme du tableau ordonné suivant :

| CODE du FB | FB_TYPE | Instance |
|---|---|---|
| 0x01 | LIN | LIN₁ |
| 0x02 | THR | THR₁ |
| 0x01 | LIN | LIN₂ |
| 0x02 | THR | THR₂ |
| 0x01 | LIN | LIN₃ |
| 0x02 | THR | THR₃ |
| 0x01 | LIN | LIN₄ |
| 0x02 | THR | THR₄ |
| 0x03 | VOTER | VOTER |
| 0x04 | AND | AND |
| 0x00 | STOP | STOP |

Autrement dit, selon la présente invention un seul bloc fonctionnel FB (dont le code est indiqué dans le fichier bibliothèque précédemment décrit) est éxécuté à la fois, selon les instances successives de la série de blocs fonctionnels indiquée dans le fichier informatique de séquence 46 ci-dessus.

Une telle exécution en série garantit le déterminisme d'éxécution de l'application de contrôle commande puisque les données de sortie de chaque blocs fonctionnels sont stockées et/ou réinjectées en entrée du bloc fonctionnel suivant au fur et à mesure des instances.

Selon l'art antérieur, pour réaliser l'application de contrôle commande représentée sur la figure 2, il est nécessaire que le FPGA comprenne quatre blocs fonctionnels de type LIN, quatre blocs fonctionnels de type THR, un bloc fonctionnel de type VOTER et un bloc fonctionnel de type AND soit au total environ dix blocs fonctionnels distincts.

Au contraire, selon la présente invention un seul bloc fonctionnel de chaque type est nécessaire et « appelé » autant de fois que requis selon l'application de contrôle commande à exécuter. Ainsi, en relation avec l'exemple d'application de la figure 2, le nombre de blocs fonctionnels nécessaires pour exécuter une telle application est réduit de dix à quatre, ce qui permet une réduction de la taille du FPGA (i.e. optimisation de la compacité) et/ou la possibilité d'y intégrer des blocs fonctionnels appelables pour d'autres applications de contrôle commande.

En d'autres termes, l'empreinte matérielle (e.g. empreinte VHDL) du circuit logique programmable selon l'invention est unique et permanente, un bloc fonctionnel qualifié étant propre à être réutilisé d'une application de contrôle commande à une autre. Selon l'invention, seul le programme applicatif 34 est distinct d'une application de contrôle commande à une autre, un même bloc fonctionnel étant par exemple appelé en première instance pour une première application de contrôle commande et en dernière instance pour une deuxième application de contrôle commande différente de la première.

Le fichier informatique 40 de valeur(s) paramètre(s) de blocs fonctionnel(s) comprend quant à lui les valeurs des paramètres nécessaires lors de l'exécution de la séquence 46, ces valeurs de paramètres étant ordonnées en tenant compte de la séquence 46 d'exécution des blocs fonctionnels.

Le fichier informatique 40 de valeurs de paramètres est représenté, par exemple sous la forme du tableau ordonné suivant :

| Valeur de paramètre | Instance du bloc fonctionnel | Valeur de paramètre |
|---|---|---|
| 0x0000000042c80000 | THR₁ | 100.0 |
| 0x0000000042c80000 | THR₂ | 100.0 |
| 0x0000000042c80000 | THR₃ | 100.0 |
| 0x0000000042c80000 | THR₄ | 100.0 |

En d'autres termes, pour l'exemple d'application de contrôle commande représenté sur la figure 2, le même bloc fonctionnel FBᵢ₌₅ de type THR est instancié quatre fois avec la même valeur de paramètre à savoir une température de 100°C.

Selon d'autres exemples d'applications de contrôle commande, des valeurs différentes de paramètres sont propres à être associées aux différentes instances du bloc fonctionnel FBᵢ₌₅ de type THR. Ainsi, sans modification de l'empreinte matérielle (e.g. empreinte VHDL), et en conséquence sans requalification du circuit programmable, la présente invention permet un changement de paramètre d'un même bloc fonctionnel au cours de la vie d'un système de contrôle commande, ou encore d'une application à l'autre. L'évolution de fonctionnement du circuit programmable est donc facilitée.

De plus, comme indiqué précédemment le programme applicatif 34 comprend également deux fichiers informatiques 42 et 44 listant respectivement pour chaque bloc fonctionnel d'une part la ou les adresses de la mémoire 38 allouée(s) à une ou des opérandes d'entrées de ce bloc fonctionnel, et d'autre part la ou les adresses de la mémoire allouée(s) à une ou des opérandes de sortie de ce bloc fonctionnel.

En relation avec l'application représentée sur la figure 2, ces deux fichiers informatiques 42 et 44 sont, par exemple, respectivement sous la forme suivante :

| Adresse(s) mémoire | Nom de la valeur d'entrée | Utilisée en entrée de : | | Adresse(s) mémoire | Nom de la valeur de sortie | Utilisée en sortie de : |
|---|---|---|---|---|---|---|
| 0x0001 | ina_E1 | LIN | | 0x0800 | wa_a1 | LIN |
| 0x0800 | wa_a1 | THR | | 0x0804 | wa_b1 | THR |
| 0x0005 | ina_E2 | LIN | | 0x0805 | wa_a2 | LIN |
| 0x0805 | wa_a2 | THR | | 0x0809 | wb_b2 | THR |
| 0x0009 | ina_E3 | LIN | | 0x080A | wa_a3 | LIN |
| 0x080A | wa_a3 | THR | | 0x080E | wb_b3 | THR |
| 0x0013 | ina_E4 | LIN | | 0x080F | wa_a4 | LIN |
| 0x080F | wa_a4 | THR | | 0x0813 | wb_b4 | THR |
| 0x0804 | wb_b1 | VOTER | | 0x0814 | wb_c | VOTER |
| 0x0809 | wb_b2 | VOTER | | 0xF800 | outb_ACT | AND |
| 0x080E | wb_b3 | VOTER | | | | |
| 0x0813 | wb_b4 | VOTER | | | | |
| 0x0000 | Inb_P1 | AND | | | | |
| 0x0814 | wb_c | AND | | | | |

Le module d'exécution 22 fonctionne alors comme une machine d'état et distribue et/ou stocke automatiquement à chaque instance de bloc fonctionnel les valeurs d'entrées et de sortie aux adresses mémoires indiquées dans les fichiers 42 et 44 du programme applicatif 34.

Un pointeur permet au module d'exécution 22 de connaitre pour chaque instance de bloc fonctionnel l'emplacement de départ des adresses des valeurs d'entrées et de sortie à lire dans les fichiers 42 et 44. A l'issu de l'exécution de chaque instance de bloc fonctionnel, celui-ci met à jour le pointeur en fonction du nombre de valeurs d'entrée lues et du nombre de valeurs de sortie générées, permettant au module d'exécution 22 de connaître les adresses à lire dans les fichiers 42 et 44 pour l'instance de bloc suivante.

En d'autres termes, les fichiers informatiques du programme applicatif 34 ont un effet de synergie de sorte que le module d'exécution 22 est configuré pour tous les prendre en compte en parallèle afin de mettre en oeuvre une exécution en série sans qu'aucun lien ne soit physiquement créé entre les différents blocs fonctionnels.

Ainsi, en relation avec l'exemple d'application de contrôle commande illustré sur la figure 2, le module d'exécution 22 est configuré pour lire la séquence 46 et déterminer quel est le premier bloc fonctionnel à exécuter.

Ce premier bloc est le bloc fonctionnel FB, de type LIN, et le module d'exécution 22 est alors configuré pour lui distribuer en entrée, conformément au fichier informatique 42 associé aux données d'entrées de chaque bloc fonctionnel, la valeur analogique de ina_E1 qui est mémorisée à l'adresse 0x0001 du sous-espace 58 dédié aux données analogiques d'entrée de la mémoire 38.

Le bloc fonctionnel FB, de type LIN est alors exécuté et la valeur analogique de wa_a1 délivrée en sortie est stockée à l'adresse 0x0800 du sous-espace mémoire 60 dédié aux données analogiques temporaires conformément au fichier informatique 44 associé aux données de sortie de chaque bloc fonctionnel.

Puis, le module d'exécution 22 est configuré pour lire la séquence 46 et déterminer quel est le deuxième bloc fonctionnel à exécuter. Ce deuxième bloc est le bloc fonctionnel FBᵢ₌₅ de type THR et le code 0x02 lui est alloué sur la carte FPGA. Le module d'exécution 22 est alors configuré pour lui distribuer en entrée la valeur de wa_a1 qui est mémorisée à l'adresse 0x0800 ainsi que la valeur de paramètre 100.0 qui est la prochaine valeur sur la pile des valeurs de paramètres analogiques.

Le bloc fonctionnel FB₅ de type THR est alors exécuté et la valeur binaire de wb_b1 délivrée en sortie est écrite et stockée, par le module d'exécution 22 à l'adresse 0x0804 du sous-espace 54 dédié aux données binaires temporaires.

Ensuite, conformément à la séquence 46, le troisième bloc fonctionnel à exécuter est à nouveau le bloc fonctionnel FB, de type LIN. Lors de cette deuxième instance de ce même bloc fonctionnel FB, de type LIN le module d'exécution 22 est alors configuré pour lui distribuer en entrée la valeur analogique de ina_E2 qui est mémorisée à l'adresse 0x0005 du sous-espace 58 dédié aux données analogiques d'entrée de la mémoire 38.

Le bloc fonctionnel FB, de type LIN est alors exécuté pour la deuxième fois et la valeur analogique de wa_a2 délivrée en sortie est stockée à l'adresse 0x0805 du sous-espace mémoire 60 dédié aux données analogiques temporaires, et ainsi de suite jusqu'à ce que l'ensemble de la séquence 46 soit complètement exécutée (i.e. jusqu'à ce que le code 0x00 d'arrêt soit lu par le module d'exécution 22).

Ainsi, selon la présente invention un seul bloc fonctionnel est exécuté à la fois à un instant donné.

Selon l'exemple représenté sur la figure 1, l'unité fonctionnelle 14 comprend en outre une pluralité 64 de M unités de calcul en virgule flottante (FPU de l'anglais « *floating point units* ») parallélisables, avec M un entier.

De telles unités de calcul sont par exemple propres à mettre en oeuvre des calculs de racine carrée ou de logarithme et sont parallélisées, pour la mise en oeuvre de calculs complexes requis lors de l'exécution d'un blocs fonctionnel tel que la détermination du rapport entre le flux thermique d'apparition de la crise d'ébullition et le flux thermique réel dans le coeur d'un réacteur appelé rapport de flux thermique critique/RFTC (DBNR de anglais *Departure from Nucleate Boiling Ratio*)*.* Un tel pool d'unités de calcul en virgule flottante est partagé pour l'ensemble des blocs fonctionnels de l'unité fonctionnelle 14 et permet d'accélérer la capacité de calcul d'un bloc fonctionnel lorsque celui-ci est configuré pour mettre un calcul analogique complexe. La scalabilité du circuit logique programmable 10 est en conséquence accrue.

L'unité fonctionnelle 14 comprend également une interface 66 d'entrée sortie propre à recevoir et à retransmettre respectivement les données d'entrée ina_E1, ina_E2, ina_E3, ina_E4 et de sortie inb_P1 et outb_ACT répertoriées dans le fichier de configuration 36, et associées à l'application de contrôle commande dans son ensemble.

L'interface 66 est propre à recevoir le programme applicatif 34 via un bus de configuration interne (ICB de l'anglais *Internai Configuration Bus*) connecté au module 12 de contrôle des signaux d'entrées et à transmettre via ce même bus de données des données de contrôle et de diagnostic au module 16 de contrôle des signaux de sortie.

Le module 12 de contrôle des signaux d'entrées comme le module 16 de contrôle des signaux de sortie sont externes à l'unité fonctionnelle 14 et sont propres à communiquer avec des appareils et/ou circuits externes au circuit logique programmable 10.

Ce module de contrôle de signaux d'entrées 12 et ce module de contrôle des signaux de sortie 16 sont eux-mêmes chacun une machine d'état comprenant un ou plusieurs espaces mémoires dédiés respectivement à des données analogiques et binaires non représentés.

Parmi ces espaces mémoires dédiés, certains sont dédiés au contrôle des données d'entrée et de sorties échangées avec un réseau de communication et propres à recevoir/transmettre des données émises/transmises de manière asynchrone au regard du cycle de fonctionnement du circuit logique programmable 10. Pour ce faire, ces espaces mémoires dédiés spécifiquement aux données réseaux sont des registres à bascule(s) synchrone(s) (i.e. à double port, de l'anglais *flip-flop*) de sorte à stocker les données réseaux reçues/transmises en cours de cycle courant pendant que les données réseaux reçues/transmises au cours du cycle précédent sont utilisées par l'unité fonctionnelle 14 au cours du cycle courant. Le circuit logique programmable 10 possède de ce fait un certain nombre de connecteurs fibre optique permettant d'émettre/recevoir ces données sur des réseaux de communication.

Les modules 12 et 16 sont notamment configurés pour assurer la communication avec un module 68 de maintenance et de diagnostic (SMD de l'anglais *Service Maintenance Diagnosis Module*) représenté sur la figure 3.

Un tel module de maintenance et de diagnostic 68 permet notamment de charger, sur le circuit logique programmable 10, le programme applicatif 34 associé à l'application à exécuter ou encore des changements de paramètres de blocs fonctionnel (e.g. un changement de seuil de température de 100°C à 120°C), de lancer périodiquement des tests de maintenance sur le circuit logique programmable 10, ou encore de transférer du circuit logique programmable 10 selon l'invention au module de maintenance et de diagnostic 68 des données de traitement. Ces échanges de données entre le circuit logique programmable 10 et le module de maintenance et de diagnostic 68 sont sécurisés au moyen d'une liaison tel qu'un bus 70 connecté à la face arrière (de l'anglais *backplane bus*) des boitiers logeant respectivement le circuit logique programmable 10 et le module de maintenance et de diagnostic 68.

Le module de maintenance et de diagnostic 68 comprend également un circuit logique programmable 72, par exemple FPGA et un microprocesseur 74, et est propre à communiquer selon une procédure sécurisée avec une centrale de maintenance 76 comprenant, par exemple, le générateur automatique 110, au moyen d'une liaison 78 de type Ethernet et un commutateur 80 propre à communiquer avec d'autres dispositifs de commande d'installation électrique, un dispositif de commande comprenant au moins un circuit logique programmable 10 selon l'invention tel que décrit précédemment.

La centrale de maintenance 76 est, par exemple, distante de l'installation électrique nucléaire sur laquelle le circuit logique programmable 10 est mis en oeuvre. Au sein de cette centrale de maintenance 76, un opérateur de maintenance réalise au moyen d'un éditeur graphique (ne requérant pas de connaissance préalable en langage VHDL ou encore Verilog) les applications de contrôle commande à mettre en oeuvre au sein de l'installation électrique nucléaire, sous forme de diagrammes fonctionnels 120 comme représentés par exemple, sur la figure 2. Comme indiqué précédemment, les diagrammes fonctionnels 120 sont ensuite convertis en programme applicatif 34, par le générateur automatique 110 qui utilise le fichier bibliothèque 100 pour garantir que le programme applicatif 34 s'exécutera sans affecter la configuration qualifiée du circuit logique programmable 10. Le programme applicatif 34 est ensuite chargé via le module de maintenance et de diagnostic 68 dans le circuit logique programmable 10.

Trois variantes d'architectures d'un tel dispositif de commande 81 sont respectivement représentées sur les figures 4 à 6.

Sur la figure 4, le dispositif de commande 81 est « mono-» circuit logique programmable 10. En d'autres termes, le dispositif de commande 81 comprend un logement 82 (de l'anglais *rack*) formant boitier, par exemple de taille 6U (U étant l'unité de hauteur d'un rack), dans lequel un seul circuit logique programmable 10 est intégré. Le logement 82 est propre à comprendre en outre un module d'alimentation 84, et des modules auxiliaires, à savoir un ou des modules 86 dédiés à l'acquisition de données d'entrées distinctes, et un ou des modules 88 dédiés à la publication de données de sortie distinctes, et un ou des modules de maintenance et de diagnostic 68 précédemment décrit. Par ailleurs, le circuit logique programmable 10 comprend des connecteurs (par exemple sept connecteurs non représentés) permettant, par exemple au moyen de fibre(s) optique(s), une connexion à un réseau de communication.

Une connexion du générateur automatique 110 de programme applicatif 34 au dispositif de commande 81 est propre à être établie via le ou les modules de maintenance et de diagnostic 68, qui est notamment configuré pour charger la séquence 46 de blocs fonctionnels à exécuter dans dispositif de commande 81 une fois qu'une telle connexion est établie.

Au sein du logement 82, le circuit logique programmable 10 est maître et contrôle la communication avec les modules auxiliaires 86, 88, et 68 au travers d'un bus 70 utilisant par exemple non limitatif des liaisons de transmission différentielle basse tension (M-LVDS de l'anglais *Multipoint-Low Voltage Differential Signaling*), opérant par exemple à 50MHz, et dédiées respectivement aux données d'entrée binaires et analogiques et aux données de sortie binaires et analogiques du circuit logique programmable 10. Avantageusement, chaque type de données (entrée ou sortie) dispose d'une liaison de transmission indépendante pour les données binaires et les données analogiques. Dans le cas de figure cela fait donc quatre liaisons de transmission différentielle basse tension.

De nombreuses variantes de réalisation non représentées pourront être mises en oeuvre sans pour autant sortir de la portée de l'invention. Par exemple les modules 86 dédiés à l'acquisition des données d'entrées, et les modules 88 dédiés à la publication des données de sortie pourront être logés sur une même carte électronique du type « GPIO » (de l'anglais *general purpose input output*) connue par ailleurs.

Le module d'alimentation 84 délivre une alimentation stabilisée en puissance aux autres modules du logement 82 et est également configuré pour mettre en oeuvre une conversion de tension, par exemple de 24 volts en courant continu à 5 volts pour alimenter chaque module du logement 82.

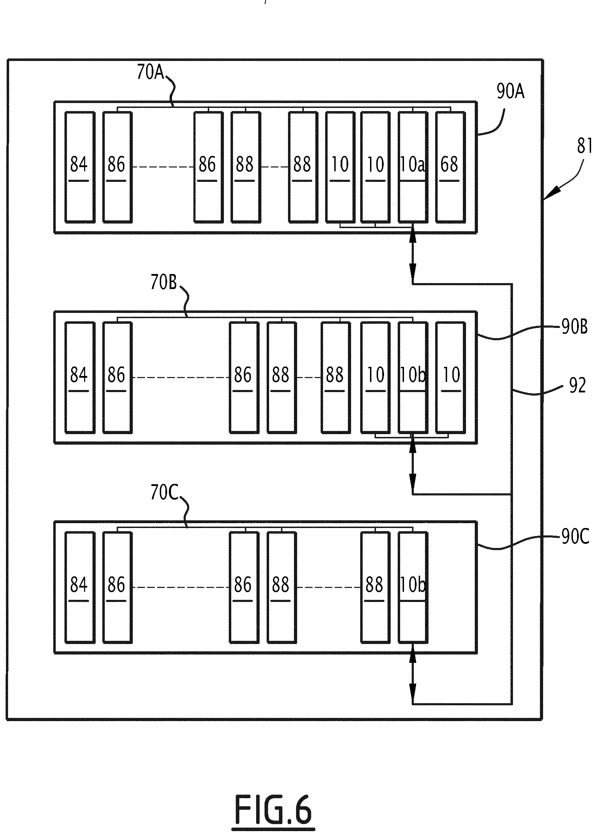

Les figures 5 et 6 représentent deux variantes de dispositifs de commande 81 comprenant une pluralité de circuits logiques programmables 10 représentés en figure 1.

Une telle architecture « multi-» circuits logiques programmables 10 permet d'accroitre le nombre d'interface réseau par dispositif de commande, de dupliquer des opérations de contrôle commande dans au moins deux circuits logiques programmables 10 à des fins de contrôle de sûreté imposant des règles de redondance, ou encore optimiser le routage inter-modules au sein d'un logement 82.

Dans une telle architecture « multi-» circuits logiques programmables 10, la pluralité de circuits logiques programmables 10 est synchronisée, cette synchronisation est réalisée par l'intermédiaire d'un circuit logique maître 10a parmi les circuits logiques programmables 10, connecté à une horloge.

Le circuit logique programmable maître 10a est notamment propre à émettre, via le module 12 de contrôle des signaux représenté sur la figure 1, une impulsion de synchronisation en début et/ou en fin de cycle (un cycle ayant par exemple une durée de 2ms) et une requête d'état vers les modules 86 dédiés à des données d'entrées distinctes, les modules 88 dédiés à des données de sortie distinctes, ou encore vers les autres circuits logiques programmables 10 afin de synchroniser et rafraichir à chaque cycle les données d'entrées/sorties du cycle suivant (nouvelle itération de la même application de contrôle commande). En conséquence, contrairement aux échanges via des réseaux de communication, ces échanges de données au sein d'une même pluralité de circuits logiques programmables sont effectués sur un mode synchrone.

Ainsi, tous les circuits logiques programmables 10 de la pluralité sont configurés pour fonctionner simultanément au sein d'un même cycle.

Deux variantes non limitatives d'une telle architecture « multi-» circuits logiques programmables 10, sont représentées sur les figures 5 et 6 à titre d'illustration.

Sur la figure 5, trois circuits logiques programmables, comprenant un circuit logique programmable maitre 10a et deux autres circuits logiques programmables 10, sont, logés dans le même logement 82, les circuits logiques programmables 10 et 10a, étant propres à communiquer entre eux et avec les modules auxiliaires 86, 88, 68 du logement 82 de manière synchrone. Dans le mode de réalisation représenté par la figure 5 les circuits logiques programmables 10a et 10 communiquent entre eux de manière synchrone par fibre optique 92, des connecteurs étant spécifiquement dédiés à cette communication inter-circuit logique programmable au sein d'une architecture « multi-» - circuits. Par ailleurs, le circuit logique programmable 10a maitre communique de manière synchrone avec les modules auxiliaires 86, 88, 68 du logement 82 au moyen du bus 70.

Sur la figure 6, une architecture de dispositif de commande 81 « multi- » circuit logique programmable 10a et 10 et « multi-» logements 90A, 90B, 90C, est représentée. Selon cette architecture multi-circuit et multi-logement, chaque logement 90A, 90B, 90C correspond à un arrangement décrit dans la figure 4 (Mono-Circuit) ou dans la figure 5 (Multi-Circuit).

Chaque logement peut comprendre en outre des modules auxiliaires 86, 88, 68.

De façon préférée, un des logements 90A est « maître » et comprend le circuit logique programmable maitre 10a pour l'ensemble des circuits logiques programmables 10 du dispositif de commande 81 multi-circuits et multi-logements, et assurant la synchronisation des modules auxiliaires 86, 88, 68 de son logement par le biais du bus 70A.

Les circuits logiques programmables 10 du dispositif de commande 81 sont propres à communiquer d'un logement à l'autre et au sein d'un même logement de manière synchrone par fibre optique 92.

Chaque logement 90B, 90C « esclave » du logement maître 90A comprend parmi ses circuits logiques programmables 10 un circuit logique programmable de sychonisation10b pour synchroniser les modules auxiliaires 86, 88, 68 de son logement par le biais du bus 70B, 70C du logement

Dans les modes de réalisations des figures 5 et 6, et sans que cela ne soit une limitation de la portée de l'invention, un seul module de maintenance et de diagnostic 68 est mis en oeuvre par dispositif de commande 81, indépendamment du nombre de circuit(s) logique(s) programmable(s) 10 ou du nombre de logement(s) qu'il comprend.

Dans les modes de réalisations des figures 5 et 6, et sans que cela ne soit une limitation de la portée de l'invention, seuls le circuit logique programmable maître 10a et les circuits logiques programmables de synchronisation 10b sont reliés aux modules auxiliaires 86, 88, 68 de leur logement respectif 90A, 90B, 90C par le biais de leur bus respectif 70A, 70B, 70C. Les autres circuits logiques programmables 10 d'un logement sont reliés aux modules auxiliaires 86, 88, 68 de leur logement par l'intermédiaire, respectivement, du circuit logique programmable maitre 10a ou du circuit logique programmable de synchronisation 10b, et du réseau de fibre optique 92. Dans cette configuration, un bus 70A, 70B, 70C comprend avantageusement quatre liaisons de transmission différentielle basse tension (M-LVDS de l'anglais *Multipoint-Low Voltage Differential Signaling*), opérant par exemple à 50MHz. dans chaque sens de transmission.

Dans un autre mode de réalisation non représenté, les bus 70A, 70B, 70C peuvent être dimensionnés pour permettre à chaque circuit logique programmable 10 d'être connecté aux modules auxiliaires 86, 88, 68 de son logement à travers le bus 70A, 70B, 70C.

## Revendications

1. Circuit logique programmable (10) de commande d'une installation électrique, en particulier une installation nucléaire, le circuit logique programmable comprenant une unité fonctionnelle (14) comprenant :
- une pluralité de types de blocs fonctionnels (FB₁, FBᵢ, FB_{N}), deux types de blocs fonctionnels distincts étant propres à exécuter au moins une fonction distincte,
- au moins un module de traitement propre à recevoir au moins une séquence (46) de bloc/s fonctionnel/s à exécuter, la séquence (46) de bloc/s fonctionnel/s à exécuter étant un fichier informatique listant un ordre d'instanciation des blocs fonctionnels à exécuter en série pour réaliser une application de contrôle commande,
- au moins une mémoire (38) interne configurée pour stocker au moins ladite séquence (46), le circuit logique programmable comprenant un seul bloc fonctionnel de chaque type, un même bloc fonctionnel étant propre à être appelé plusieurs fois, et un module d'exécution (22) configuré pour exécuter en série le ou les bloc/s fonctionnel/s appelé/s selon ladite séquence (46).

2. Circuit logique programmable (10) selon la revendication 1, dans lequel le circuit logique programmable (10) est de type FPGA.

3. Circuit logique programmable (10) selon la revendication 1 ou 2, dans lequel le module d'exécution (22) est une machine d'état.

4. Circuit logique programmable (10) selon l'une quelconque des revendications précédentes, dans lequel l'unité fonctionnelle (14) comprend en outre une pluralité (64) d'unités de calcul en virgule flottante (FPU) parallélisables.

5. Circuit logique programmable (PM) selon l'une quelconque des revendications précédentes, dans lequel au moins un module de traitement est propre à recevoir un programme applicatif (34) correspondant à un groupe de fichiers informatiques de configuration comprenant ladite séquence et au moins un autre fichier informatique appartenant au groupe comprenant :
- un fichier de configuration (36) de la mémoire (38) correspondant à une table associant à au moins un signal d'entrée/sortie du circuit logique programmable (PM) une adresse dans sa mémoire (38),
- un fichier (40) de valeur/s de paramètre/s de bloc/s fonctionnel/s propre/s à exécuter au moins une fonction utilisant un paramètre,
- un fichier (42) listant, pour chaque bloc fonctionnel, la ou les adresse/s de la mémoire allouée/s à une ou des entrée/s de ce bloc fonctionnel,
- un fichier (44) listant, pour chaque bloc fonctionnel, la ou les adresse/s de la mémoire allouée/s à une ou des sortie/s de ce bloc fonctionnel.

6. Circuit logique programmable (PM) selon la revendication 5, dans lequel les valeurs de paramètres sont ordonnée/s au sein de leur fichier (40) en fonction de ladite séquence de bloc/s fonctionnel/s à exécuter.

7. Circuit logique programmable (PM) selon l'une quelconque des revendications précédentes, dans lequel la mémoire (38) comprend au moins deux espaces (48, 50) de stockage de données dédiés respectivement à des données binaires et à des données analogiques.

8. Circuit logique programmable (PM) selon la revendication 7, dans lequel chaque espace (48, 50) de stockage comprend au moins trois sous-espaces dédiés:
- au moins un sous-espace (52,58) dédié aux données d'entrées du circuit logique programmable (10),
- au moins un sous-espace (56,62) dédié aux données de sorties du circuit logique programmable (10),
- au moins un sous-espace (54,60) dédié à des données temporaires obtenues en cours d'exécution de ladite séquence (46).

9. Circuit logique programmable (PM) selon la revendication 8, dans lequel les sous-espaces (52, 58) dédiés aux données d'entrée ou les sous-espaces dédiés (56, 62) aux données de sortie sont des registres à bascule/s synchrone/s.

10. Dispositif de commande d'une installation électrique, en particulier une installation nucléaire, **caractérisé en ce que** le dispositif de commande comprend au moins un circuit logique programmable (10) selon l'une quelconque des revendications précédentes 1 à 9.

11. Dispositif de commande d'une installation électrique selon la revendication 10, dans lequel le dispositif de commande comprend une pluralité de circuits logiques programmables (10) selon l'une quelconque des revendications précédentes 1 à 9.

12. Dispositif de commande d'une installation électrique selon les revendications 10 ou 11 comprenant en outre :
- au moins un module d'alimentation (84),
- des modules auxiliaires parmi un ou des modules (86) dédiés à l'acquisition de données d'entrées distinctes, un ou des modules (88) dédiés à la publication de données de sortie distinctes, et un ou des modules de maintenance et de diagnostic (68), et
- un bus de communication (70) configuré pour relier le ou les circuit/s logique/s programmable/s (10) aux modules auxiliaires (86, 88, 68).

13. Dispositif de commande d'une installation électrique selon la revendication 12 dans lequel le bus de communication (70) comprend quatre liaisons de transmission différentielle basse tension (M-LVDS) dédiées respectivement aux données d'entrée et aux données de sortie de chaque circuit logique programmable (10) dans chaque sens de transmission.

14. Dispositif de commande d'une installation électrique selon l'une quelconque des revendications 11 à 13, comprenant un réseau de communication fibre optique (92) configuré pour relier la pluralité de circuits logiques programmables (10).

15. Dispositif de commande d'une installation électrique selon l'une quelconque des revendications 11 à 14, dans lequel un circuit logique programmable maitre (10a), parmi la pluralité de circuits logiques programmables (10), est propre à être connecté à une horloge et est configuré pour synchroniser les autres circuits logiques programmables de la pluralité de circuits logiques programmables (10) par le biais du réseau de communication fibre optique (92).

16. Dispositif de commande d'une installation électrique selon la revendication 15, dans lequel le circuit logique programmable maitre (10a) est également configuré pour synchroniser les modules auxiliaires par le biais du bus de communication (70).

17. Dispositif de commande d'une installation électrique selon l'une quelconque des revendications 11 à 16, dans lequel la pluralité de circuits logiques programmables (10, 10a, 10b) est logée dans un même logement (82).

18. Dispositif de commande d'une installation électrique selon l'une quelconque des revendications 11 à 17, dans lequel les circuits logiques programmables (10, 10a, 10b) de la pluralité des circuits logiques programmables sont séparés dans au moins deux logements distincts (90_{A}, 90_{B}, 90_{C}).

## Patentansprüche

1. Programmierbare Logikschaltung (10) zum Steuern einer elektrischen Anlage, insbesondere einer Kernanlage, die programmierbare Logikschaltung umfassend eine Funktionseinheit (14), umfassend:
- eine Vielzahl von Arten von Funktionsblöcken (FB₁, FBᵢ, FB_{N}), wobei zwei unterschiedliche Arten von Funktionsblöcken geeignet sind, um mindestens eine unterschiedliche Funktion auszuführen,
- mindestens ein Verarbeitungsmodul, das geeignet ist, um mindestens eine Sequenz (46) von auszuführenden Funktionsblöcken zu empfangen, wobei die Sequenz (46) von auszuführenden Funktionsblock/en eine Computerdatei ist, die eine Instanzierungsreihenfolge von Funktionsblock/en auflistet, die hintereinander auszuführen sind, um eine Steuerbefehlanwendung zu realisieren,
- mindestens einen internen Speicher (38), der konfiguriert ist, um mindestens die Sequenz (46) zu speichern,
die programmierbare Logikschaltung umfassend einen einzelnen Funktionsblock von jedem Typ, wobei ein einzelner Funktionsblock geeignet ist, um mehrmals aufgerufen zu werden, und ein Ausführungsmodul (22), das konfiguriert ist, um den/die aufgerufenen Funktionsblock/e gemäß der genannten Sequenz (46) seriell auszuführen.

2. Programmierbare Logikschaltung (10) nach Anspruch 1, wobei die programmierbare Logikschaltung (10) vom Typ FPGA ist.

3. Programmierbare Logikschaltung (10) nach Anspruch 1 oder 2, wobei das Ausführungsmodul (22) eine Zustandsmaschine ist.

4. Programmierbare Logikschaltung (10) nach einem der vorherigen Ansprüche, wobei die Funktionseinheit (14) ferner eine Vielzahl (64) von parallelisierbaren Gleitkommaberechnungseinheiten (FPUs) umfasst.

5. Programmierbare Logikschaltung (PM) nach einem der vorherigen Ansprüche, wobei mindestens ein Verarbeitungsmodul geeignet ist, um ein Anwendungsprogramm (34) zu empfangen, das einer Gruppe von Konfigurationscomputerdateien entspricht, umfassend die Sequenz und mindestens eine weitere Computerdatei, die zu der Gruppe gehört, die Folgendes umfasst:
- eine Konfigurationsdatei (36) des Speichers (38), die einer Tabelle entspricht, die mit mindestens einem Eingangs-/Ausgangssignal der programmierbaren Logikschaltung (PM) eine Adresse in ihrem Speicher (38) assoziiert,
- eine Datei (40) mit Parameterwert/en von Funktionsblock/en, die geeignet sind, um unter Verwendung eines Parameters mindestens eine Funktion auszuführen,
- eine Datei (42), die für jeden Funktionsblock die Adresse(n) des assoziierten Speichers/einer oder mehrerer Eingänge/dieses Funktionsblocks auflistet,
- eine Datei (44), die für jeden Funktionsblock die Adresse(n) des assoziierten Speichers/einer oder mehrerer Ausgänge/dieses Funktionsblocks auflistet.

6. Programmierbare Logikschaltung (PM) nach Anspruch 5, wobei die Parameterwerte innerhalb ihrer Datei (40) entsprechend der Sequenz der auszuführenden Funktionsblöcke/n geordnet sind.

7. Programmierbare Logikschaltung (PM) nach einem der vorherigen Ansprüche, wobei der Speicher (38) mindestens zwei Datenspeicherräume (48, 50) umfasst, die jeweils binären Daten und analogen Daten dediziert sind.

8. Programmierbare Logikschaltung (PM) nach Anspruch 7, wobei jeder Speicherraum (48, 50) mindestens drei dedizierte Unterräume umfasst:
- mindestens einen Unterraum (52, 58), der den Eingangsdaten der programmierbaren Logikschaltung (10) dediziert ist,
- mindestens einen Unterraum (56, 62), der den Ausgangsdaten der programmierbaren Logikschaltung (10) dediziert ist,
- mindestens einen Unterraum (54, 60), der temporären Daten dediziert ist, die während der Ausführung der genannten Sequenz (46) erlangt werden.

9. Programmierbare Logikschaltung (PM) nach Anspruch 8, wobei die den Eingangsdaten gewidmeten Unterräume (52, 58) oder die den Ausgangsdaten gewidmeten Unterräume (56, 62) synchrone/n Flip-Flop-Register sind.

10. Steuervorrichtung für eine elektrische Anlage, insbesondere eine Kernanlage, **dadurch gekennzeichnet, dass** die Steuervorrichtung mindestens eine programmierbare Logikschaltung (10) nach einem der vorherigen Ansprüche 1 bis 9 umfasst.

11. Steuervorrichtung für eine elektrische Anlage nach Anspruch 10, wobei die Steuervorrichtung eine Vielzahl von programmierbaren Logikschaltungen (10) nach einem der vorherigen Ansprüche 1 bis 9 umfasst.

12. Steuervorrichtung für eine elektrische Anlage nach den Ansprüchen 10 oder 11, ferner umfassend:
- mindestens ein Versorgungsmodul (84),
- Hilfsmodule aus einem oder mehreren Modulen (86), die der Erfassung von separaten Eingangsdaten dediziert sind, einem oder mehreren Modulen (88), die der Veröffentlichung von separaten Ausgangsdaten dediziert sind, und einem oder mehreren Wartungs- und Diagnosemodulen (68); und
- einen Kommunikationsbus (70), der konfiguriert ist, um die programmierbare(n) Logikschaltung(en) (10) mit den Hilfsmodulen (86, 88, 68) zu verbinden.

13. Steuervorrichtung für eine elektrische Anlage nach Anspruch 12, wobei der Kommunikationsbus (70) vier Niederspannungs-Differenzübertragungsverbindungen (M-LVDS) umfasst, die jeweils den Eingangsdaten und den Ausgangsdaten jeder programmierbaren Logikschaltung (10) in jeder Übertragungsrichtung dediziert sind.

14. Steuervorrichtung für eine elektrische Anlage nach einem der Ansprüche 11 bis 13, umfassend ein faseroptisches Kommunikationsnetzwerk (92), das konfiguriert ist, um die Vielzahl von programmierbaren Logikschaltungen (10) zu verbinden.

15. Steuervorrichtung für eine elektrische Anlage nach einem der Ansprüche 11 bis 14, wobei eine programmierbare logische Masterschaltung (10a) aus der Vielzahl von programmierbaren Logikschaltungen (10) geeignet ist, um mit einem Taktgeber verbunden zu werden und konfiguriert ist, um die anderen programmierbaren Logikschaltungen der mehreren programmierbaren Logikschaltungen (10) über das faseroptische Kommunikationsnetzwerk (92) zu synchronisieren.

16. Steuervorrichtung für eine elektrische Anlage nach Anspruch 15, wobei die programmierbare Master-Logikschaltung (10a) auch konfiguriert ist, um die Hilfsmodule über den Kommunikationsbus (70) zu synchronisieren.

17. Steuervorrichtung für eine elektrische Anlage nach einem der Ansprüche 11 bis 16, wobei die Vielzahl von programmierbaren Logikschaltungen (10, 10a, 10b) in einem einzigen Gehäuse (82) untergebracht ist.

18. Steuervorrichtung für eine elektrische Anlage nach einem der Ansprüche 11 bis 17, wobei die programmierbaren Logikschaltungen (10, 10a, 10b) der Vielzahl von programmierbaren Logikschaltungen in mindestens zwei verschiedenen Gehäusen (90_{A}, 90_{B}, 90_{C}) getrennt sind.

## Claims

1. A programmable logic circuit (10) for controlling an electrical facility, in particular a nuclear facility, the programmable logic circuit comprising an operating unit (14) comprising:
- a plurality of types of functional blocks (FB₁, FBᵢ, FB_{N}), two distinct types of functional blocks being suitable for executing at least one distinct function,
- at least one processing module suitable for receiving at least one sequence (46) of functional block/s to be executed, the sequence (46) of functional block/s to be executed being a computer file listing an instantiation order of the functional blocks to be to be executed in series to perform a control-command application,
- at least one internal memory (38) configured to store at least said sequence (46),
the programmable logic circuit comprising a single functional block of each type, a same functional block being suitable for being called several times, and an execution module (22) configured to execute the called functional block/s in series, according to said sequence (46).

2. The programmable logic circuit (10) according to claim 1, wherein the programmable logic circuit (10) is of the FPGA type.

3. The programmable logic circuit (10) according to claim 1 or 2, wherein the execution module (22) is a finite-state machine.

4. The programmable logic circuit (10) according to any one of the preceding claims, wherein the operating unit (14) further comprises a plurality (64) of parallelizable floating point units (FPU).

5. The programmable logic circuit (PM) according to any one of the preceding claims, wherein at least one processing module is suitable for receiving an application program (34) corresponding to a group of computer configuration files comprising said sequence and at least one other computer file belonging to the group comprising:
- a configuration file (36) of the memory (38) corresponding to a table associating, with at least one input/output signal of the programmable logic circuit (PM), an address in its memory (38),
- a file (40) with value/s of parameter/s of functional block/s suitable for executing at least one function using a parameter,
- a file (42) listing, for each functional block, the address/es of the memory allocated to one or more input/s of this functional block,
- a file (44) listing, for each functional block, the address/es of the memory allocated to one or more output/s of this functional block.

6. The programmable logic circuit (PM) according to claim 5, wherein the parameter values are sequenced within their file (40) as a function of said sequence of functional block/s to be executed.

7. The programmable logic circuit (PM) according to any one of the preceding claims, wherein the memory (38) comprises at least two data storage areas (48, 50) respectively dedicated to binary data and analog data.

8. The programmable logic circuit (PM) according to claim 7, wherein each storage area (48, 50) comprises at least three dedicated subareas:
- at least one subarea (52, 58) dedicated to the input data of the programmable logic circuit (10),
- at least one subarea (56, 62) dedicated to the output data of the programmable logic circuit (10),
- at least one subarea (54, 60) dedicated to temporary data obtained during execution of said sequence (46).

9. The programmable logic circuit (PM) according to claim 8, wherein the subareas (52, 58) dedicated to the input data or the subareas (56, 62) dedicated to the output data are synchronous flip-flop/s registers.

10. A control device for controlling an electrical facility, in particular a nuclear facility, **characterized in that** the control device comprises at least one programmable logic circuit (10) according to any one of the preceding claims 1 to 9.

11. The control device for controlling an electrical facility according to claim 10, wherein the control device comprises a plurality of programmable logic circuits (10) according to any one of the preceding claims 1 to 9.

12. The control device for controlling an electrical facility according to claim 10 or 11, further comprising:
- at least one power module (84);
- auxiliary modules among one or several modules (86) dedicated to acquiring distinct input data, one or several modules (88) dedicated to publishing distinct output data, and one or several service maintenance diagnosis modules (68), and
- a communication bus (70) configured to link the programmable logic circuit/s (10) to the auxiliary modules (86, 88, 68).

13. The control device for controlling an electrical facility according to claim 12, wherein the communication bus (70) comprises four multipoint-low voltage differential signaling (M-LVDS) links respectively dedicated to the input data and the output data of each programmable logic circuit (10) in each transmission direction.

14. The control device for controlling an electrical facility according to any one of claims 11 to 13, comprising a fiber-optic communication network (92) configured to link the plurality of programmable logic circuits (10).

15. The control device for controlling an electrical facility according to any one of claims 11 to 14, wherein a master programmable logic circuit (10a), among the plurality of programmable logic circuits (10), is suitable for being connected to a clock and is configured to synchronize the other programmable logic circuits of the plurality of programmable logic circuits (10) by means of the fiber-optic communication network (92).

16. The control device for controlling an electrical facility according to claim 15, wherein the master programmable logic circuit (10a) is also configured to synchronize the auxiliary modules by means of the communication bus (70).

17. The control device for controlling an electrical facility according to any one of claims 11 to 16, wherein the plurality of programmable logic circuits (10, 10a, 10b) is housed in a same rack (82).

18. The control device for controlling an electrical facility according to any one of claims 11 to 17, wherein the programmable logic circuits (10, 10a, 10b) of the plurality of programmable logic circuits are separated in at least two distinct racks (90_{A}, 90_{B}, 90_{C}).
